# EUROPEAN PATENT APPLICATION

(11) **EP 1 422 321 A1**
(43) Date of publication of application: **26.05.2004**
(21) Application number: 03257312.3
(22) Date of filing: 19.11.2003
(51) Int. Cl.: C30B 15/14, G02B 1/02, C30B 29/12

(54) **As-grown single crystal of calcium fluoride**

(30) Priority: 19.11.2002 JP 2002334625
(71) Applicant: Tokuyama Corporation, Yamaguchi (JP)
(72) Inventor: Nawata, Teruhiko, Shunan-shi Yamaguchi (JP); Kuramoto, Nobuyuki, Shunan-shi Yamaguchi (JP); Yanagi, Hiroyuki, Shunan-shi Yamaguchi (JP); Fukuda, Tsuguo, Shunan-shi Yamaguchi (JP)
(74) Representative: Hall, Matthew Benjamin

(57) **Abstract**

The object of the present invention is to provide an as-grown single crystal of calcium fluoride having a large diameter and small birefringence. The as-grown single crystal of calcium fluoride according to the present invention is obtained by a single crystal pulling method (Czochralski method), has a straight barrel part diameter of 17 cm or more, preferably has a straight barrel part length of 50 mm or more, and has a birefringence of not more than 3 nm/cm, preferably 0.1 to 2.0 nm/cm.

## Description

The present invention relates to an as-grown single crystal of calcium fluoride produced by a single crystal pulling method.

Single crystals of metal fluorides such as calcium fluoride and barium fluoride have high transmittance over a wide wavelength region, cause little light scattering and have excellent chemical stability. Therefore, a requirement for them as optical materials, such as lenses and aperture materials of various instruments using laser beam of ultraviolet wavelength or vacuum ultraviolet wavelength, cameras and CVD devices, has been widespread. Particularly, calcium fluoride single crystals are expected as projection lenses used with F₂ laser (157 nm) which has been developed as a short wavelength light source of the next generation in the photolithographic technology. As the projection lenses, those having a diameter of 15 cm or more are generally adopted in order to improve throughput of lithography, and hence, large-sized calcium fluoride single crystals having a diameter of more than 17 cm are required as the lens materials.

Such large-sized calcium fluoride single crystals have been generally produced heretofore by a crucible depression method (Bridgman's method). The crucible depression method is a method wherein a melt of a starting material for forming a single crystal in a crucible is cooled with slowly depressing the crucible containing the starting material to thereby grow a single crystal in the crucible.

In the as-grown single crystal of calcium fluoride produced by the crucible depression method, however, large internal strain is produced because the single crystal is formed in a closed space of the crucible, and in order to reduce this strain, annealing treatment over a period of more than 1 month is necessary after the growth of the single crystal. Further, especially when a large-sized single crystal of more than 17 cm is grown, the crystal is partially polycrystallized, and hence there is a disadvantage of extremely bad yield.

In order to remove the disadvantage of the crucible depression method, it is proposed to prepare the calcium fluoride single crystals by a single crystal pulling method (Czochralski method). The single crystal pulling method is a method wherein a seed crystal made of the desired single crystal is brought into contact with a melt of a starting material for forming a single crystal placed in a crucible and then slowly pulled from the heating zone of the crucible to cool it and thereby grow a single crystal below the seed crystal. Because the single crystal pulling method is not restricted spatially to the crucible during the single crystal growth, strain relatively rarely occurs inside the crystal. Moreover, reduction of impurities due to segregation phenomenon during the crystal growth is possible, and hence, the single crystal pulling method is generally employed for producing semiconductor single crystals such as silicon and germanium.

In the single crystal pulling method, however, the apparatus is complicated, and besides, it is difficult to stably grow single crystals, so that in the application of this method to the production of the calcium fluoride single crystals, considerable difficulties are foreseen. With regard to the production of calcium fluoride single crystals by the single crystal pulling method, therefore, an example wherein a small-sized single crystal having a straight barrel part diameter of not more than 10 cm is produced on a labo-scale is only known (see Shinichiro Tozawa, Nobuo Fukuda and 5 others, "Modification of Optical Material CaF₂", report of technical research by Institute for Material Research of Tohoku University, March 2001, No. 19, and K. Nassau, *Journal of Applied Physics,* Vol. 32, 1820-1 (1961)), and in the actual circumstances, production of a large-sized single crystal having a straight barrel part diameter of 17 cm or more is rarely known.

In Japanese Patent Laid-Open Publication No. 21197/1999, an example of production of a calcium fluoride single crystal of a large diameter by a pulling method is described. The single crystal obtained in this publication, however, has large irregularity of birefringence even after it is subjected to annealing treatment for a long period of time. This suggests that the single crystal obtained by the method of the above publication shows higher birefringence when it is in the as-grown state. Although the cause is not always clear, it is thought that in the pulling apparatus described in the above publication, the temperature distribution in the single crystal pulling zone becomes nonuniform to thereby cause internal strain of the crystal.

Under such circumstances as mentioned above, the present inventors have attempted to produce a large-sized calcium fluoride single crystal having a straight barrel part diameter of 17 cm or more by the single crystal pulling method. In the production of the single crystal by the use of a single crystal pulling apparatus of commonly known structure, however, the internal strain of the resulting single crystal in the as-grown state could not be sufficiently reduced. On this account, the birefringence of the resulting single crystal exceeded 5 nm/cm, and in order to use the single crystal for the lithography, long-time annealing treatment was necessary. Thus, such a single crystal was still unsatisfactory. The above phenomenon was not observed at all in the production of a small-sized calcium fluoride single crystal on a labo-scale as previously described, and this is a serious obstacle to the industrial production of the aforesaid large-sized calcium fluoride single crystals.

Accordingly, it is an object of the present invention to produce an as-grown single crystal of calcium fluoride having a straight barrel part diameter of 17 cm or more and having small internal strain and sufficiently small birefringence by the single crystal pulling method.

The present inventors have earnestly studied to solve the above problems. As a result, they first succeeded in producing a large-sized as-grown single crystal of calcium fluoride having extremely small birefringence by a single crystal pulling method, and accomplished the present invention.

The as-grown single crystal of calcium fluoride according to the present invention is produced by a single crystal pulling method and has a straight barrel part diameter of 17 cm or more and a birefringence of not more than 3 nm/cm. In the as-grown single crystal of calcium fluoride of the invention, the standard deviation of the birefringence is preferably not more than 2.0 nm/cm.

In the as-grown single crystal of calcium fluoride, further, the straight barrel part preferably has a length of not less than 5 cm.

Certain preferred embodiments will now be described in greater detail by way of example only and with reference to the accompanying drawing, in which:

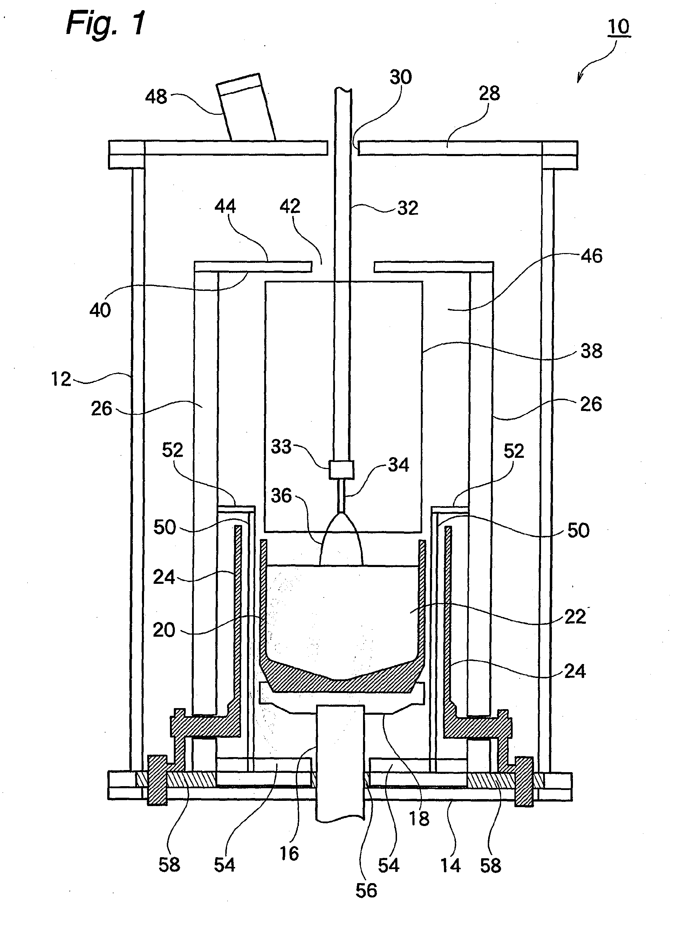

Fig. 1 is a schematic view of a single crystal pulling apparatus favorably used for producing the as-grown single crystal of calcium fluoride of the present invention.

The single crystal of calcium fluoride of the invention is a single crystal in an as-grown state produced by a single crystal pulling method. The single crystal pulling method means a single crystal production method generally called Czochralski method. The single crystal in an as-grown state means a single crystal having been pulled in a single crystal production apparatus and subjected to only cooling to room temperature, and is a single crystal having been subjected to no post treatment such as annealing treatment.

The single crystal of the invention is a large-diameter single crystal having a straight barrel part diameter of 17 cm or more, preferably 20 to 40 cm. The ingot grown by the single crystal pulling method generally consists of a shoulder part of conical configuration in which the diameter is gradually increased from that of the seed crystal, a straight barrel part of cylindrical configuration in which the diameter of the ingot is almost constant, and a tail part of conical configuration in which the diameter is gradually decreased from that of the straight barrel part. The diameter of the single crystal of the invention means a diameter of the biggest portion of the straight barrel part.

The most characteristic feature of the present invention is that the internal strain of the large-diameter as-grown single crystal of calcium fluoride produced by the single crystal pulling method is remarkably reduced. The strain inside the calcium fluoride single crystal induces birefringence, and therefore, the degree of the internal strain can be expressed as a degree of birefringence. Accordingly, the birefringence of the as-grown single crystal of calcium fluoride of the invention is a small value of not more than 3 nm/cm, preferably 0.1 to 2.0 nm/cm.

In the as-grown single crystal of calcium fluoride of the invention, the standard deviation of the birefringence is preferably not more than 2.0 nm/cm, more preferably not more than 1.5 nm/cm, particularly preferably not more than 1.3 nm/cm, and in the invention, birefringence of high uniformity can be attained.

When the large-diameter calcium fluoride single crystal is produced by a general single crystal pulling method, it is difficult to obtain a single crystal of an as-grown state having small and uniform birefringence, such as the single crystal of the present invention, as previously described. In the present invention, however, uniform and small birefringence can be realized in the large-sized as-grown single crystal, and from the resulting single crystal, a large-diameter optical material employable for the lithography can be cut out even if the single crystal is not subjected to long-time annealing treatment. Moreover, because the strain inside the crystal is extremely small, cracks hardly occur in the machining operation such as cutting or polishing of the single crystal, and hence high-yield machining becomes feasible.

In the present invention, the birefringence of the as-grown single crystal is measured in the following manner. A cylindrical body constituted of a straight barrel part obtained by cutting off a shoulder part and a tail part from the as-grown single crystal is subjected to mirror polishing on its upper and lower surfaces, whereby a measuring object is obtained. On each of the upper and the lower surfaces of the measuring object, a square inscribed on a circle drawn 1 cm inward from the peripheral edge of the measuring object is taken as a measuring section, and on the measuring section, a lattice consisting of 1 mm-spaced vertical lines and 1 mm-spaced horizontal lines is drawn to select measuring points. At the measuring points, values of partial birefringence are measured, and their average is calculated to determine birefringence of the as-grown single crystal.

A value of birefringence at each measuring point can be measured by a method publicly known in this art. In a preferred example of the method, a measuring light is transmitted perpendicularly between the upper and the lower surfaces of the measuring object, and a phase difference is measured using orthogonal two kinds of polarized lights to determine the birefringence. The wavelength of the measuring light is a wavelength of He-Ne laser beam (632.8 nm).

The irregularity of the birefringence is evaluated by the use of a standard deviation of all the measured values.

In the single crystal of the invention, the length of the straight barrel part is preferably 5 cm or more. When the length of the straight barrel part is 5 cm or more, the numerical aperture of, for example, a lithographic lens obtained from the single crystal can be increased, and as a result, formation of an extremely fine projected pattern can be achieved.

Although the process for producing the single crystal of the invention having the above-mentioned properties is not specifically restricted, the single crystal of the invention can be preferably produced by the following process.

That is to say, there is used a single crystal pulling apparatus having a single crystal pulling chamber wherein a single crystal pulling zone above a crucible is surrounded with a heat-insulating wall and an upper end opening of this surrounding heat-insulating wall is closed with a ceiling board in which at least an inserting hole for a single crystal pulling bar is formed and which has a coefficient of thermal conductivity of 1000 to 50000 W/m²·K in the thickness direction. In the growth of a single crystal, pulling is desirably conducted at a crystal pulling rate of not more than 4 mm/hr, preferably 0.5 to 3.5 mm/hr.

Fig. 1 is a schematic view showing an example of a single crystal pulling apparatus having above structure.

A single crystal pulling apparatus 10 comprises a chamber 12 constituting a crystal growth furnace, and the chamber 12 includes a rotatable support shaft 16 to penetrate through a bottom wall 14 of the chamber 12.

The lower end of the support shaft 16 penetrates through the bottom wall 14 of the chamber 12 and is extended out of the chamber 12, and comes in contact with a cooler and is then connected to a driving mechanism for rotating and vertically moving a crucible 20, which is not shown.

Moreover, a base 18 is fixed to the support shaft 16 and the crucible 20 is mounted on the upper surface of the base 18. A molten solution 22 of a single crystal manufacturing material is filled in the crucible 20.

A melting heater 24 is erected from the bottom wall 14 of the chamber 12 to surround the crucible 20. Furthermore, a heat insulating wall 26 is erected from the bottom wall 14 of the chamber 12 to surround the melting heater 24 and the crucible 20.

On the other hand, a vertical movable and rotatable single crystal pulling bar 32 is hung down from an upper wall 28 of the chamber 12 through an opening portion 30 by means of the driving means which is not shown. A seed crystal 34 is attached to the tip of the single crystal pulling bar 32 through a holding tool 33, and the seed crystal 34 is provided to be positioned on the central axis of the crucible 20.

In the single crystal pulling apparatus 10 having such a structure, the single crystal pulling bar 32 is brought down toward the molten solution 22 of a single crystal manufacturing material set in a melting state in the crucible 20 by the heating operation of the melting heater 24. Then, the lower end plane of the seed crystal 34 provided on the tip of the single crystal pulling bar 32 comes in contact with the molten material solution 22 in the crucible 20 and the single crystal pulling bar 32 is thereafter pulled up so that a single crystal 36 is grown under the seed crystal 34.

In the single crystal pulling apparatus of Fig. 1, the heat insulating wall 26 is extended to be upward longer than that in the single crystal pulling apparatus used for manufacturing a single crystal of silicon or the like. In addition, the heat insulating wall 26 surrounds (circularly encloses) a whole circumference from a lower end to an upper end in the crucible 20, and furthermore, surrounds the side peripheral portion of a single crystal pulling region 38 provided thereabove.

The single crystal pulling region 38 implies a region from a height of the upper end of the crucible 20 to a height that the upper end of the single crystal 36 of calcium fluoride to be grown (that is, a lower end plane of a seed crystal) reaches at the end of pulling, in the upper part of the crucible 20 in the chamber 12.

In this case, the uppermost portion of the single crystal pulling region 38 is varied depending on the length of the single crystal 36 to be pulled, and usually, is generally positioned in a place which is higher than the upper end of the crucible 20 by 50 to 300%, and particularly suitably, 100 to 200% of the maximum inside diameter of the crucible 20.

The height of the upper end of the heat insulating wall 26 is set in such a manner that the single crystal pulling region 38 having such a size is sufficiently held in a single crystal pulling chamber which will be described below. If the upper end of the heat insulating wall 26 is much higher than the uppermost portion of the single crystal pulling region 38, a temperature retaining effect becomes excessive so that a single crystal cannot be obtained. For this reason, it is preferable that the height should be selected from the same range as that of the uppermost portion of the single crystal pulling region 38.

The heat insulating wall 26 formed by a well-known heat insulating material can be employed without limit. In order to reduce internal strain of the single crystal 36, a coefficient of thermal conductivity in a direction of a thickness is preferably 50 W/m²· K or less, more preferably 1 to 20 W/m²· K, particularly 3 to 15 W/m²· K.

The coefficient of thermal conductivity in the direction of the thickness represents a value obtained by dividing a mean thermal conductivity (W/m· K) at 1500°C in the direction of the thickness of an object by a thickness (m).

The material of the heat insulating wall 26 having such a coefficient of thermal conductivity preferably has a thermal conductivity of 0.2 to 1.0 W/m· K and more preferably 0.3 to 0.8 W/m· K at 1500°C. More specifically, examples of the material include a pitch type graphite mold heat insulating material (for example, trade name of "DONACARBO"), a fiber type graphite mold heat insulating material, a carbon felt type heat insulating material, a porous carbon type heat insulating material and the like.

The pitch type graphite mold heat insulating material is used particularly preferably because it can achieve a desired coefficient of thermal conductivity and is excellent in a resistance to a severe environment in the pulling and a mechanical strength.

If the heat insulating wall 26 is excellent in a heat insulating property as a whole, moreover, in addition to the wall member formed by a single material, it is also possible to employ a structure in which a plurality of plate-shaped members including at least one kind of heat insulating plate is provided, and furthermore, a structure in which these plate-shaped members are provided with a gas phase interposed therebetween. The thickness of the heat insulating wall 26 is not particularly restricted but is generally 3 to 10 cm.

In the chamber 12 seen from above, a position in which the heat insulating wall 26 is to be provided on the outside of the crucible 20 is not particularly restricted. Usually, the melting heater 24 is provided around the crucible 20. For this reason, the heat insulating wall 26 is generally positioned on the outside of the melting heater 24. If a great distance is made from the outer end of the crucible 20, the heat retaining effect of the single crystal pulling region 38 is deteriorated. Therefore, a distance of 20 to 100%, and particularly preferably 30 to 60% of the maximum inside diameter of the crucible 20 is made.

An upper end opening portion 40 formed on an upper end in the circular enclosure of the heat insulating wall 26 is closed by a ceiling board 44 on which an inserting hole 42 for the single crystal pulling bar 32 is at least formed. Since the single crystal pulling region 38 is held in a single crystal pulling chamber 46 formed by the heat insulating wall 26 and the ceiling board 44, consequently, a heat retaining property thereof can be enhanced greatly.

The single crystal pulling apparatus having the above-mentioned structure has the greatest feature that the ceiling board 44 having a coefficient of thermal conductivity of 1000 to 50000 W/m²· K in a direction of a thickness. In the single crystal pulling chamber 46, consequently, a heat radiation from the ceiling board 44 is also increased properly. Therefore, the single crystal pulling chamber is cooled slowly in a radial direction and a direction of a height. As a result, the nonuniformity of a temperature distribution can be improved remarkably.

Therefore, the single crystal 36 is cooled slowly and uniformly in the single crystal pulling region 38 so that a crystal can be grown more stably. Consequently, the single crystal of calcium fluoride is obtained with extremely reduced strain.

In consideration of the expressing property of such an effect, the coefficient of thermal conductivity in the direction of the thickness of the ceiling board 44 is particularly preferably 1000 to 50000 W/m²· K, and most preferably 2000 to 20000 W/m²· K.

In most cases in which the coefficient of thermal conductivity in the direction of the thickness of the ceiling board 44 is smaller than 1000 W/m²· K, a heat radiation from the ceiling board 44 becomes insufficient so that a temperature gradient in the direction of the height of the single crystal pulling region 38 is not sufficient and a single crystal is not generated. Also in the case in which the growth of the single crystal is generated, moreover, a temperature distribution in the single crystal pulling region 38 becomes nonuniform so that internal strain and birefringence increase. On the other hand, in the case in which the coefficient of thermal conductivity in the direction of the thickness of the ceiling board 44 is greater than 50000 W/m²· K, the temperature gradient in the direction of the height is excessively increased, and it is difficult to stably growing single crystal, resulting in the increase of birefringence.

The material of the ceiling board 44 having such a coefficient of thermal conductivity preferably has a thermal conductivity of 15 to 200 W/m· K and more preferably 30 to 150 W/m· K at 1500°C. More specifically, examples of the material include graphite, tungsten and the like.

The graphite is used particularly preferably because it can achieve a desired coefficient of thermal conductivity and is excellent in a resistance to a severe environment in the pulling and a mechanical strength.

If the ceiling board 44 satisfies the value of the coefficient of thermal conductivity as a whole, moreover, in addition to the plate member formed by a single material in the same manner as in case of the heat insulating wall 26, it is also possible to employ a structure in which a plurality of plate-shaped members including at least one kind of heat radiating plate is provided, and furthermore, a structure in which these plate-shaped members are provided with a gas phase interposed therebetween.

Moreover, the ceiling board 44 does not need to be flat-plate but takes any shape which closes the upper end opening portion 40 of the circular enclosure of the heat insulating wall 26 excluding an aperture portion which will be described below. For example, it is also possible to take the shapes of a truncated cone, an inverted truncated cone, a shade, an inverted shade, a dome, an inverted dome and the like.

If the ceiling board 44 is flat-plate, the height of the ceiling board 44 is equal to that of the upper end of the heat insulating wall 26. When the ceiling board 44 takes the shape of an upward convex from the upper end of the heat insulating wall 26 described above, moreover, the height of the highest portion is set to be the height of the ceiling board.

When the ceiling board 44 takes the shape of a downward concave from the upper end of the heat insulating wall 26 described above, furthermore, the height of the lowest portion is set to be that of the ceiling board 44. In the same manner as the height of the flat-plate ceiling board, it is effective that the height of the ceiling board which is not flat plate is also set to be the height of the upper end of the heat insulating wall 26, that is, the same ceiling board is positioned in a higher place than the upper end of the crucible 20 by 50 to 500% of the maximum inside diameter of the crucible 20.

The thickness of the ceiling board 44 is not particularly restricted but is generally 0.3 to 3 cm and preferably 0.5 to 1.5 cm.

In addition to the inserting hole 42 of the single crystal pulling bar 32, the ceiling board 44 may be properly provided with an observation hole for maintaining a field of view from the inspection window 48 provided on the top of the chamber, a working hole for putting in a mechanism for scooping a solid impurity floating over the surface of the molten material solution 22 and the like.

It is also possible to control the heat radiating property in the single crystal pulling chamber 46 by regulating the total opening area of the apertures formed on the ceiling board 44. An upward gradient of a reduction in a temperature of the single crystal pulling region 38 can be controlled to be proper for pulling a single crystal of calcium fluoride. When the heat radiating performance of the ceiling board 44 is not controlled to have the value but the gradient of the temperature is controlled by simply regulating the total opening area of the apertures, however, the generation of a strain cannot be prevented highly, which is not preferable.

The total opening area of the apertures is preferably 5 to 60% of the opening area of the upper end in the circular enclosure of the heat insulating wall 26 and particularly preferably 8 to 40%.

In the case in which the characteristic structure as mentioned above is employed in a large-sized single crystal pulling apparatus for calcium fluoride in which an internal strain is generated on a single crystal particularly remarkably and a crucible has a large diameter, advantages can be produced particularly remarkably, which is suitable.

Next, description will be given to the other structures of the single crystal pulling apparatus. The melting heater 24 is not particularly restricted but a resistance heating method, an induction heating method or the like is used. It is preferably a resistance heater. If the heater is an induction heater, the temperature distribution in the oven tends to become steep. Hence, the resistance heater is advantageous to obtain a single crystal of high quality. It is preferable that an upper end of the heater 24 should have a height which is almost equal to or slightly greater than the height of the upper end of the crucible 20.

A partition wall 50 may be provided circumferentially between the melting heater 24 and the outer end of the crucible 20 in order to cause a radiant heat from the heater to be uniform. It is preferable that the upper end of the partition wall 50 should be slightly higher than that of the melting heater 24 and a lid member 52 for closing a gap between the partition wall 50 and the heat insulating wall 26 should be provided between the upper end and the heat insulating wall 26, thereby closing the gap to prevent the heat of the melting heater 24 from being let upward.

The partition wall 50 has such function that uniforming the radiant heat from the melting heater 24 to heat the crucible 20. The lid member 52 has such function that preventing the heat of the melting heater 24 from being let upward. In order to further reduce strain of the single crystal, it is effective to further uniforming the temperature around the liquid surface of the molten solution and to grow the single crystal around the liquid surface of the molten solution with gradually cooling. The structure mentioned above is effective to realize these advantages.

The lid member 52 is preferably positioned in a higher place than the upper end of the crucible 20 by 2 to 50%, preferably 3 to 20 % of the distance from upper end of the crucible 20 to ceiling board 44.

The distance between partition wall 50 and outer end of crucible 20 is preferably 1 to 10cm, more preferably 3 to 6 cm.

It is preferable that the materials of the partition wall 50 and the lid member 52 should be graphite.

In the single crystal pulling apparatus, it is preferable that the single crystal pulling bar 32, the support shaft 16, the inspection window 48 and the like should be sealed in airtightness by means of an O ring, a magnetic fluid seal or the like. When a leakage is generated from these portions in a process for melting a material calcium fluoride or a process for raising a crystal, there is a possibility that a remarkable deterioration in quality such as coloring of a single crystal or a reduction in a transparency might be caused.

It is preferable that the material calcium fluoride put in the crucible 20 should be subjected to a heating process under reduced pressure prior to melting to remove an adsorbed moisture. While a well-known vacuum pump for evacuating an apparatus can be used, it is preferable to use a combination of a rotary pump and an oil diffusing pump, or a combination of a rotary pump and a further molecular pump.

As shown in Fig. 1, furthermore, a bottom heat insulating member 54 is provided on the inner peripheral side of the heat insulating wall 26 at the bottom wall 14 of the chamber 12. Moreover, a heat insulating support shaft airtight seal member 56 is provided between the periphery of the support shaft 16 and the bottom heat insulating member 54. Furthermore, a heat insulating bottom airtight seal member 58 is provided between the lower end of the heat insulating wall 26, the outer periphery of the bottom heat insulating member 54 and the melting heater 24.

Consequently, it is possible to prevent the heat from being let out of the bottom portion of the chamber 12 and to prevent the atmosphere of the chamber 12 from leaking to the outside.

The materials of the bottom heat insulating member 54, the support shaft airtight seal member 56 and the bottom airtight seal member 58 are not particularly restricted but any material having the same coefficient of thermal conductivity in a direction of a thickness as that of the heat insulating wall 26 which is formed by a well-known heat insulating material can be employed without limit.

In the most preferred single crystal pulling apparatus used for producing the single crystal of the invention, the coefficient of thermal conductivity of the heat-insulting wall 26 in the thickness direction is in the range of 3 to 15 W/m²·K, the coefficient of thermal conductivity of the ceiling board 44 in the thickness direction is in the range of 2000 to 20000 W/m²·K, the total opening area of the hole formed in the ceiling board is in the range of 8 to 40% of the upper end opening area of the upper end in the circular enclosure heat-insulating wall 26, the position of the ceiling board 44 is higher than the upper edge of the crucible 20 by 100 to 200% of the maximum inner diameter of the crucible, a partition wall 50 and a lid member 52 are provided, the position of the lid member 52 is higher than the upper edge of the crucible 20 by 3 to 20% of the distance between the upper edge of the crucible 20 and the ceiling board 44, and the distance between the heat-insulating wall 26 and the outer edge of the crucible 20 is in the range of 30 to 60% of the maximum inner diameter of the crucible 20.

In order to produce the single crystal of the invention by the use of the single crystal pulling apparatus of the above structure, it is important to grow the single crystal at the aforesaid crystal pulling rate. If the crystal pulling rate is too fast, it becomes difficult to sufficiently reduce the birefringence of the resulting single crystal.

With regard to the operations of other pulling methods, those publicly known, which are performed by the use of a general single crystal pulling apparatus, are adoptable without any restriction. It is preferable to use, as the starting calcium fluoride introduced into the crucible, calcium fluoride having been subjected to purifying treatment sufficiently, particularly moisture removal treatment. Melting of the starting fluoride and growth of a single crystal can be carried out in an atmosphere of an inert gas or under vacuum.

Pulling of the single crystal is preferably carried out with monitoring the temperature of the bottom of the crucible in which the starting calcium fluoride is melted. The pulling is preferably carried out at a temperature, as measured on the bottom of the crucible, of 1380 to 1480°C. The heating rate to reach this temperature is in the range of preferably 50 to 500°C/hr.

In order to remove an influence by the residual moisture, it is preferable to carry out the pulling method in the presence of a scavenger. As the scavenger, a solid scavenger fed with the starting calcium fluoride, such as zinc fluoride, lead fluoride or polyethylene tetrafluoride, or a gas scavenger introduced into the chamber as a gas of the atmosphere, such as carbon tetrafluoride, is employed. Of these, the solid scavenger is preferably employed, and the amount thereof is preferably in the range of 0.005 to 5 parts by weight based on 100 parts by weight of the starting calcium fluoride.

The seed crystal used in the pulling method is a single crystal of calcium fluoride. Although the growth plane of the seed crystal can be optionally selected, the (111)plane can be preferably employed. If a plane other than the (111)plane is used, the birefringence of the resulting single crystal sometimes becomes large. During the growth of the single crystal, it is preferable to rotate the seed crystal on its pulling axis, and the rotational speed is preferably in the range of 2 to 20 rpm. With the rotation of the seed crystal, the crucible may also be rotated at the same rotational speed in the opposite direction to the rotational direction of the seed crystal. After pulling of the single crystal, the temperature is lowered down to ordinary temperature at a rate of preferably 0.1 to 3°C/min.

The as-grown single crystal of calcium fluoride obtained as above has only to be cut and polished to give an optical member of a desired shape. The birefringence of the single crystal is extremely small as previously described, but when the birefringence value is desired to be further decreased, the single crystal may be subjected to annealing treatment. Specifically, the annealing treatment is desirably carried out at 900 to 1300°C for 1 to 48 hours.

### EXAMPLE

The as-grown single crystal of calcium fluoride of the present invention is further described with reference to the following examples, but it should be construed that the invention is in no way limited to those examples.

### Example 1

Preparation of a calcium fluoride single crystal was carried out using a single crystal pulling apparatus shown in Fig. 1.

The crucible 20 made of high-purity graphite, which was set in the chamber 12, had an inner diameter of 38 cm (outer diameter: 40 cm) and a height of 30 cm. The heat-insulating wall 26 was a pitch type graphite molded heat insulator and had a coefficient of thermal conductivity of 9 W/m²·K in the thickness direction. The ceiling board 44 was made of graphite and had a heat-radiating powder of 5000 W/m²·K in the thickness direction. In the ceiling board, an observation hole to ensure view from a inspection window 48 was formed in addition to an inserting hole 42 (diameter: 14 cm) for a single crystal pulling bar 32 shown in the figure, and the total opening area thereof was 13% of the upper end opening area of the surrounding heat-insulating wall 26.

The position of the ceiling board 44 was higher than the upper edge of the crucible 20 by 160% (61 cm) of the maximum inner diameter of the crucible, and the position of the lid member 52 was higher than the upper edge of the crucible 20 by 10% (6 cm) of the distance between the upper edge of the crucible 20 and the ceiling board 44. The distance between the partition wall 50 and the outer edge of the crucible 20 was 4 cm. The distance between the heat-insulating wall 26 and the outer edge of the crucible 20 was 9 cm (25% of the maximum inner diameter of the crucible 20).

Into the crucible 20 set in the chamber 12 were introduced, as a starting material, 50 kg of a lump of high-purity calcium fluoride having been subjected to purification treatment and moisture removal treatment sufficiently and, as a scavenger, 0.1% high-purity zinc fluoride, followed by evacuating the chamber. Then, an electric current was applied to a melting heater 24 to start heating of the starting material, and the temperature was raised up to 250°C at a rate of about 50°C/hr, followed by keeping this temperature for 2 hours. After the temperature was kept, the temperature was raised again at a rate of about 100°C/hr. When a temperature of 600°C was reached, the evacuation line was shut down, and high-purity argon was fed to the chamber 12 to keep the internal pressure at 106.4 KPa.

At 1480°C, the starting material was completely melted, and this temperature was kept for 40 minutes. Thereafter, the heater output was lowered to keep the temperature at 1440°C for 120 minutes. Then, the pulling bar 32 was perpendicularly depressed to bring the lower end plane [(111)plane] of the seed crystal 34 into contact with the surface of the starting material melt 22, whereby growth of a single crystal was started. Pulling of a single crystal was conducted for 100 hours at a rate of 2 mm/hr with rotating the seed crystal 34 at 5 rpm and also rotating the crucible 20 at 1 rpm in the opposite direction to the rotational direction of the seed crystal. As a result, growth of a single crystal could be carried out satisfactorily. After the growth was completed, the temperature was lowered to ordinary temperature at a rate of 0.9°C/min.

Through the above process, an as-grown single crystal of calcium fluoride having a straight barrel part maximum diameter of 28 cm and a weight of 27 kg was prepared. The length of the straight barrel part of the as-grown single crystal was 10 cm.

The birefringence of the as-grown single crystal was measured in the following manner. First, the shoulder part and the tail part were cut off from the single crystal with a band saw to obtain a cylindrical body constituted of the straight barrel part, and the upper and the lower surfaces of the cylindrical body were mirror polished to obtain a measuring object. In the measuring object, a square (length of one side: about 18 cm) inscribed on a circle drawn 1 cm inward from the peripheral edge of the measuring object was taken as a measuring section, and on the measuring section, a lattice consisting of 1 mm-spaced vertical lines and 1 mm-spaced horizontal lines was drawn to select measuring points. At the measuring points, birefringence values were measured by the use of a birefringence measuring device (ELP-150ART type manufactured by Mizojiri Kogaku Kogyosho, measuring wavelength: 632.8 nm), and an average of the measured values was calculated to determine a birefringence of the as-grown single crystal. As a result, the birefringence was 1.375 nm/cm. The standard deviation of the measured values of the birefringence was 1.21 nm/cm.

### Example 2

Pulling of a calcium fluoride single crystal was carried out in the same manner as in Example 1, except that in the single crystal pulling apparatus of Fig. 1, a ceiling board made of tungsten and having a coefficient of thermal conductivity of 20000 W/m²·K in the thickness direction was used as the ceiling board 44. As a result, an as-grown single crystal of calcium fluoride having a straight barrel part maximum diameter of 25 cm and a weight of 19.4 kg was prepared. The length of the straight barrel part of the as-grown single crystal was 8 cm.

Measurement of birefringence of the as-grown single crystal resulted in 1.004 nm/cm. The standard deviation of the measured values of the birefringence was 0.89 nm/cm.

### Example 3

Pulling of a calcium fluoride single crystal was carried out in the same manner as in Example 1, except that in the single crystal pulling apparatus of Fig. 1, the lid member 52 was not provided. As a result, an as-grown single crystal of calcium fluoride having a straight barrel part maximum diameter of 23 cm and a weight of 17.4 kg was prepared. The length of the straight barrel part of the as-grown single crystal was 9 cm.

Measurement of birefringence of the as-grown single crystal resulted in 2.652 nm/cm. The standard deviation of the measured values of the birefringence was 2.1 nm/cm.

### Example 4

Pulling of a calcium fluoride single crystal was carried out in the same manner as in Example 1, except that pulling rate was changed to 3 mm/hr.

As a result, an as-grown single crystal of calcium fluoride having a straight barrel part maximum diameter of 21 cm and a weight of 15.2 kg was prepared. The length of the straight barrel part of the as-grown single crystal was 10 cm.

Measurement of birefringence of the as-grown single crystal resulted in 0.892 nm/cm. The standard deviation of the measured values of the birefringence was 0.63 nm/cm.

### Comparative Example 1

Pulling of a calcium fluoride single crystal was carried out in the same manner as in Example 1, except that in the single crystal pulling apparatus of Fig. 1, the ceiling board 44 was not provided. As a result, an as-grown single/crystal of calcium fluoride having a straight barrel part maximum diameter of 21 cm and a weight of 10.7 kg was prepared. The length of the straight barrel part of the as-grown single crystal was 6 cm.

Measurement of birefringence of the as-grown single crystal resulted in 3.870 nm/cm. The standard deviation of the measured values of the birefringence was 3.15 nm/cm.

### Comparative Example 2

Pulling of a calcium fluoride single crystal was carried out in the same manner as in Example 1, except that in the single crystal pulling apparatus of Fig. 1, a ceiling board being a pitch type graphite molded heat insulator and having a coefficient of thermal conductivity of 15 W/m²·K in the thickness direction was used as the ceiling board 44 and in the ceiling board only an inserting hole of 30 cm diameter for a single crystal pulling bar (opening area: 30% of the upper end opening area of the upper end in the circular enclosure heat-insulating wall 26) was formed. As a result, an as-grown single crystal of calcium fluoride having a straight barrel part maximum diameter of 22 cm and a weight of 10.0 kg was prepared. The length of the straight barrel part of the as-grown single crystal was 6 cm.

Measurement of birefringence of the as-grown single crystal resulted in 4.628 nm/cm. The standard deviation of the measured values of the birefringence was 4.05 nm/cm.

### Comparative Example 3

As a single crystal pulling apparatus, the apparatus of Fig. 1 wherein the inner diameter of the crucible was reduced to 9 cm, the ceiling board 44 was not provided, and the sizes of other parts were proportionally reduced was used.

Then, pulling of a calcium fluoride single crystal was carried out in the same manner as in Example 1, except that into the above single crystal pulling apparatus was introduced 0.9 kg of a lump of calcium fluoride as a starting material. As a result, an as-grown single crystal of calcium fluoride having a straight barrel part maximum diameter of 6 cm and a weight of 0.6 kg was prepared. The length of the straight barrel part of the as-grown single crystal was 4 cm.

Measurement of birefringence of the as-grown single crystal resulted in 2.347 nm/cm. The standard deviation of the measured values of the birefringence was 2.23 nm/cm.

### Comparative Example 4

Pulling of a calcium fluoride single crystal was carried out in the same manner as in Example 1, except that pulling of the single crystal was conducted at a rate of 10 mm/hr. As a result, an as-grown single crystal of calcium fluoride having a straight barrel part maximum diameter of 22 cm and a weight of 10.0 kg was prepared. The length of the straight barrel part of the as-grown single crystal was 6 cm.

Measurement of birefringence of the as-grown single crystal resulted in 5.703 nm/cm. The standard deviation of the measured values of the birefringence was 4.43 nm/cm.

The calcium fluoride single crystal of the invention has a large diameter and has small internal strain, small birefringence and small irregularity of birefringence though it is in an as-grown state. Therefore, from the single crystal, a large-sized optical material having advantageous properties such as high quality and high uniformity can be cut out even if the single crystal is not subjected to long-time annealing treatment. Moreover, because the strain inside the crystal is extremely small, cracks hardly occur in the machining operation such as cutting or polishing of the single crystal, and hence high-yield machining becomes feasible.

Accordingly, the calcium fluoride single crystal of the invention is useful for optical members, such as lenses, prisms, half mirrors and aperture materials, and is remarkably useful for these optical members particularly used with ultraviolet and vacuum ultraviolet lights, most preferably for materials used with F2 laser which is considered as a promising light source in the lithographic technology of the next generation.

## Claims

1. An as-grown single crystal of calcium fluoride obtained by a single crystal pulling method and having a straight barrel part diameter of 17 cm or more and a birefringence of not more than 3 nm/cm.

2. The as-grown single crystal of calcium fluoride as claimed in claim 1, wherein the standard deviation of the birefringence is not more than 2.0 nm/cm.

3. The as-grown single crystal of calcium fluoride as claimed in claim 1, wherein the straight barrel part has a length of not less than 5 cm.

4. A method of preparing a calcium fluoride single crystal having a straight barrel part diameter of 17 cm or more by a single crystal pulling method in which a single crystal pulling zone above a crucible is surrounded with a heat-insulating wall and an upper end opening of this surrounding heat-insulating wall is closed with a ceiling board having an inserting hole for a single crystal pulling bar, **characterised in that** a material for the ceiling board is selected to have a coefficient of thermal conductivity of 1000 to 50000 W/m²·K in its thickness direction to control the temperature gradient in the vertical direction within the single crystal pulling zone.

5. A method as claimed in claim 4, wherein a material for the ceiling board is selected to have a coefficient of thermal conductivity in its thickness direction of 2000 to 20000 W/m²·K.

6. A method as claimed in claim 4 or 5, wherein pulling is conducted at a crystal pulling rate of not more than 4 mm/hr.

7. A method as claimed in claim 6, wherein pulling is conducted at a crystal pulling rate of 0.5 to 3.5 mm/hr.

8. A method as claimed in any of claims 4 to 7, wherein the single crystal is pulled so that its uppermost portion reaches a position which is higher than the upper end of the crucible by 100 to 200% of the maximum inside diameter of the crucible.

9. A method as claimed in any of claims 4 to 8, wherein the single crystal is pulled using a seed crystal having an end face cut on the [111] plane which is brought into contact with the surface of the starting material melt to commence pulling of the single crystal.

10. A method as claimed in any of claims 4 to 9, wherein the seed crystal is rotated with respect to the crucible at a rotational speed of 2 to 20 rpm.
